# EUROPÄISCHE PATENTSCHRIFT

(11) **EP 1 665 489 B1**
(45) Veröffentlichungstag und Bekanntmachung des Hinweises auf die Patenterteilung: **02.05.2007**
(21) Anmeldenummer: 04786188.5
(22) Anmeldetag: 24.08.2004
(51) Int. Cl.: H02H 3/16, G01R 31/02

(54) **VERFAHREN UND SCHALTUNGSANORDNUNG ZUR ERDSCHLUSSERFASSUNG AN ELEKTRONISCHEN AUSL SERN F R NIEDERSPANNUNGS-LEISTUNGSSCHAL TER MIT VORGESCHALTETEN MESSVERST RKERN**
METHOD AND CIRCUIT ARRANGEMENT FOR THE DETECTION OF GROUND FAULTS ON ELECTRONIC TRIPS FOR LOW-VOLTAGE CIRCUIT BREAKERS COMPRISING SERIALLY CONNECTED MEASURING AMPLIFIERS
PROCEDE ET CIRCUIT POUR DETECTER UNE MISE A LA TERRE SUR DES ACTIONNEURS ELECTRONIQUES POUR INTERRUPTEURS BASSE TENSION EQUIPES D'AMPLIFICATEURS DE MESURE CONNECTES EN AMONT

(30) Priorität: 11.09.2003 DE 10342599
(43) Veröffentlichungstag der Anmeldung: 07.06.2006
(73) Patentinhaber: SIEMENS AKTIENGESELLSCHAFT, 80333 München (DE)
(72) Erfinder: PANCKE, Andreas, 13507 Berlin (DE); REDMANN, Ilka, 10555 Berlin (DE); RÖHL, Wolfgang, 13503 Berlin (DE)
(86) Internationale Anmeldenummer: PCT/DE2004/001906
(87) Internationale Veröffentlichungsnummer: WO 2005/027293

(56) Entgegenhaltungen:
- US-B1- 6 546 342
- PATENT ABSTRACTS OF JAPAN Bd. 2002, Nr. 11, 6. November 2002 (2002-11-06) & JP 2002 214256 A (NISSIN ELECTRIC CO LTD), 31. Juli 2002 (2002-07-31)
- PATENT ABSTRACTS OF JAPAN Bd. 018, Nr. 253 (P-1737), 13. Mai 1994 (1994-05-13) & JP 06 034689 A (MATSUSHITA ELECTRIC IND CO LTD), 10. Februar 1994 (1994-02-10)

## Beschreibung

Die Erfindung betrifft ein Verfahren und eine Schaltungsanordnung zur Erdschlusserfassung an elektronischen Auslösern für Niederspannungs-Leistungsschalter mit vorgeschalteten Messverstärkern.

Niederspannungs-Leistungsschalter können neben ihrer Hauptfunktion, nämlich der Kurzschluss- und Überstromüberwachung, weitere Funktionen aufweisen. Darunter zählt als wichtigste Funktion die Erdschlussüberwachung. Erdschlüsse können in elektrischen Anlagen schwerwiegende Folgen haben, indem sie beispielsweise Brände auslösen. Sie werden mit Leistungsschaltern, die eine entsprechende Erdschlusserkennungsfunktion aufweisen, deshalb zeitverzögert durch Ausschalten des Leistungsschalters beseitigt oder sie werden zumindest signalisiert. Bei zwei- oder dreipoligen Leistungsschaltern erfolgt hierzu eine vektorielle Summenbildung der Phasenströme und des Stromes im N-Leiter, falls ein N-Leiter-Stromwandler vorhanden ist. Liegt ein Reststrom über einem Ansprechwert, erfolgt eine Anzeige und gegebenenfalls eine Auslösung des Leistungsschalters. Alternativ dazu kann ein Erdschluss auch nur durch einen zusätzlichen Stromwandler im N-Leiter oder am geerdeten Sternpunkt erfasst werden.

Die Erdschlusserfassungsfunktion kann beispielsweise durch ein spezielles einsteckbares Modul am Leistungsschalter realisiert werden, wie es in der DE 694 25 916 T2 gezeigt ist.

Üblicherweise wird der von den Stromwandlern gemessene Strom über Messverstärker auf die Auslöseeinheit des Niederspannungs-Leistungsschalters gegeben. Ein solches Verfahren ist aus US 6 546 342 bekannt. Ein Problem ist hierbei, dass die Messverstärker bezüglich ihres Verstärkungsfaktors eine hohe Toleranz aufweisen. Bei der zur Erdschlusserfassung nötigen Summenbildung kann der Auslöser dann einen Erdschluss messen, obwohl das Netz erdschlussfrei ist. Auch der umgekehrte Fall ist denkbar, das heißt, es besteht ein Erdschluss, aber die Stromsumme ist annähernd Null.

Um dieses Problem zu beheben, wurde bisher im Prozessor des Auslösers eine softwaremäßige Korrektur durchgeführt. Die Stromsignale wurden anschließend softwaremäßig summiert. Es hat sich allerdings herausgestellt, dass hierbei ein erheblicher Fehler entsteht, da die zur Auslösung führenden geringen Erdschlussströme nur etwa zwei Wandlerstufen der A/D-Wandler der elektronischen Auslöseeinheit entsprechen, so dass die Phasenströme für den Zweck der ErdschLusserfassung nicht genau genug abgebildet werden.

Der Erfindung liegt die Aufgabe zugrunde, einen elektronischen Auslöser für Niederspannungs-Leistungsschalter anzugeben, der eine fehlerfreie Erfassung von Erdschlüssen erlaubt.

Erfindungsgemäß wird die Aufgabe gelöst durch die Merkmale der Ansprüche 1 und 2. Zweckmäßige Ausgestaltungen sind Gegenstand der Unteransprüche.

Danach werden die Ausgangssignale der Messverstärker auf einen pulsweitenmodulierten Summierverstärker gegeben. Die drei beziehungsweise vier Eingangssignale werden über drei beziehungsweise vier Analogschalter auf den Eingang dieses Summierverstärkers geschaltet. Durch Wahl der jeweiligen Tastverhältnisse der Analogschalter erfolgt eine Korrektur, die die Verstärkungen für die Eingänge der Erdschlussmessung auf den gleichen gewünschten Faktor bringt.

Ein Vorteil der erfindungsgemäßen Schaltung ist der Verzicht auf einen hardwaremäßigen Abgleich. Die Ungenauigkeiten der softwaremäßigen Addition entfallen. Die Verstärkungsfaktoren der Messverstärker können leicht ermittelt werden, indem in einem Test ein gleiches Eingangssignal auf jeden Stromwandler gegeben wird und die Messergebnisse dann im Mikroprozessor des Auslösers gespeichert werden. Sie können anschließend direkt bei der Ermittlung des Tastverhältnisses verwendet werden.

Die Erfindung wird nachfolgend unter Bezugnahme auf die Zeichnungen beispielhaft näher erläutert. Es zeigen:
- Figur 1: ein Beispiel für eine erfindungsgemäße Schaltung und
- Figur 2: eine zweite Variante einer erfindungsgemäßen Schaltung.

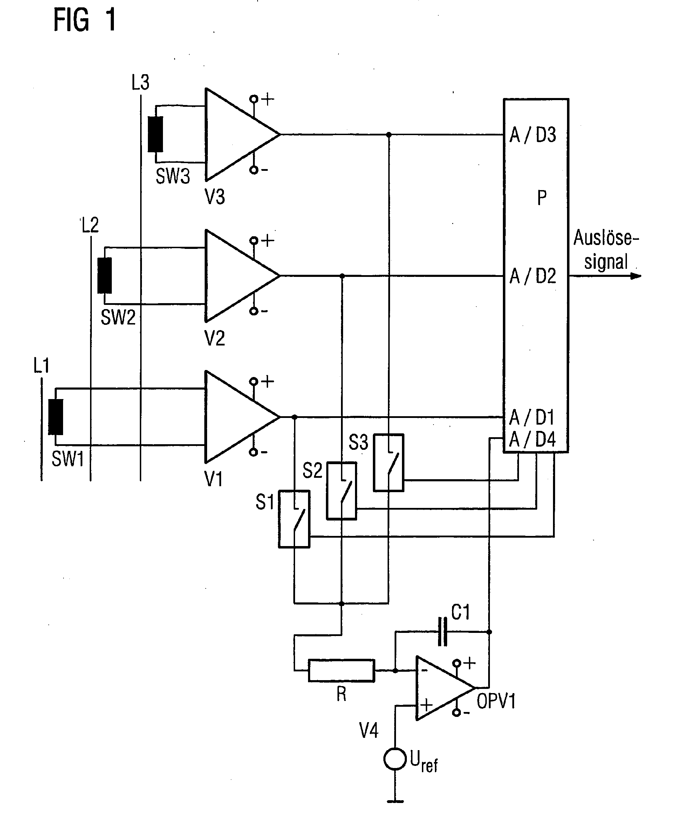

Figur 1 zeigt schematisch einen elektronischen Auslöser an einem dreiphasigen Netz. An den drei Leitern L1, L2, L3 des Netzes werden die Ströme über Stromwandler SW1, SW2, SW3 gemessen und an die Messverstärker V1, V2, V3 geleitet, deren Ausgänge auf A/D-Wandler A/D1, A/D2, A/D3 eines Mikroprozessors µP geführt sind, der den wesentlichen Funktionsteil des Auslösers darstellt.

Erfindungsgemäß werden die Ausgangssignale der Messverstärker V1, V2, V3 an Schalter S1, S2, S3 geführt, die von dem Mikroprozessor µP pulsweitenmoduliert angesteuert werden. Die hier nur schematisch gezeichneten Schalter S1, S2, S3 können zum Beispiel durch Schalttransistoren realisiert werden. Ist ein Schalter S1, S2, S3 stromführend, sind die anderen geöffnet, wobei das Tastverhältnis dem Verstärkungsfaktor des jeweils zugehörigen Messverstärkers V1, V2, V3 entspricht. Die Ausgänge der Schalter S1, S2, S3 sind auf einen Punkt geführt, der über einen Vorwiderstand R den Eingang eines Summierverstärkers V4 darstellt. Der Summierverstärker V4 wird durch eine Integrierschaltung realisiert, das heißt durch einen Operationsverstärker OPV1, dessen Ausgang über einen Kondensator C1 auf seinen Eingang zurückgekoppelt ist. Da sich die gesamte Messung im Gleichstrombereich bewegt, ist der zweite Eingang des Operationsverstärkers OPV1 mit einer Referenzspannung Uref vorgespannt, die dem Mittelwert des Spannungshubes der Messverstärker V1, V2, V3 entspricht. Das Ausgangssignal des Operationsverstärkers OPV1 wird dann an einen A/D-Wandler A/D4 des Mikroprozessors µP geführt und stellt ein Signal für die Erdschlussüberwachung dar.

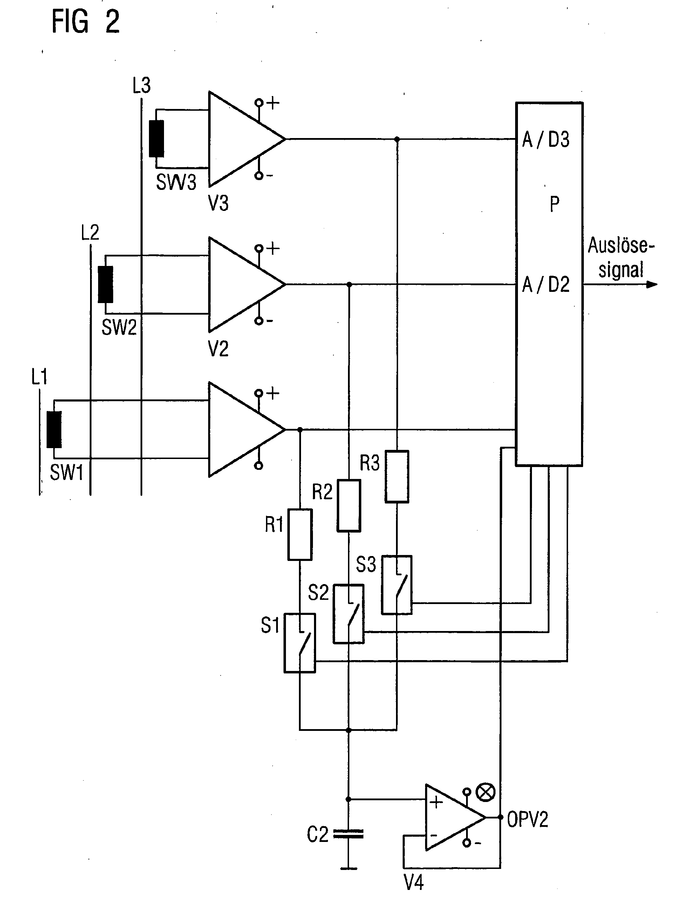

Die Schaltung nach Figur 2 unterscheidet sich von der vorbeschriebenen Variante nur dadurch, dass die Ausgangssignale der Messverstärker V1, V2, V3 über Widerstände R1, R2, R3 an die Schalter S1, S2, S3 und die Ausgänge der Schalter S1, S2, S3 direkt auf einen Kondensator C2 geführt sind, der die Stromsumme der Phasenströme der Leiter L1, L2, L3 abbildet. Über einen Operationsverstärker OPV2 geht dieses Signal an den A/D-Wandler A/D4 des Mikroprozessors µP.

## Patentansprüche

1. Verfahren zur Erdschlusserfassung an elektronischen Auslösern für Niederspannungs-Leistungsschalter mit vorgeschalteten Messverstärkern, wobei die Ausgangsignale der Messverstärker in einem Summierverstärker summiert werden,
**dadurch gekennzeichnet,**
**dass** die Ausgangssignale der Messverstärker phasenweise pulsmoduliert werden, wobei die Dauer der Pulse durch den Auslöser vom Verstärkungsfaktor des jeweils zugehörigen Messverstärkers abhängig gesteuert wird und der Ausgang des Summierverstärkers ein Signal für die Erdschlussüberwachung darstellt.

2. Schaltungsanordnung zur Erdschlusserfassung an elektronischen Auslösern für Niederspannungs-Leistungsschalter mit vorgeschalteten Messverstärkern (V1, V2, V3),
**gekennzeichnet durch**
von dem Auslöser entsprechend den Verstärkungsfaktoren der Messverstärker (V1, V2, V3) pulsweitenmoduliert ansteuerbare Schalter (S1, S2, S3), an die jeweils ein Ausgang eines Messverstärkers (V1, V2, V3) geführt ist, wobei die Ausgänge der Schalter (S1, S2, S3) gemeinsam an den Eingang eines Summierverstärkers geleitet sind, dessen Ausgang ein Signal für die Erdschlussüberwachung darstellt.

3. Schaltungsanordnung nach Anspruch 2,
**dadurch gekennzeichnet,**
**dass** der Summierverstärker ein Integrierverstärker ist, bestehend aus einem Operationsverstärker (OPV1) mit kapazitiver Rückkopplung, dessen zweiter Eingang mit einer Referenzspannung (Uref) vorgespannt ist, die dem Mittelwert des Spannungshubes der Messverstärker (V1, V2, V3) entspricht.

4. Schaltungsanordnung nach Anspruch 2,
**dadurch gekennzeichnet,**
**dass** der Summierverstärker durch einen Kondensator (C2) mit nachgeschaltetem Verstärker (OPV2) realisiert ist.

## Claims

1. Method for the detection of earth faults on electronic releases for low-voltage circuit breakers having upstream measuring amplifiers, in which method the output signals from the measuring amplifiers are summated in a summing amplifier, **characterized in that** the output signals from the measuring amplifiers are pulse-modulated in terms of phase, the duration of the pulses being controlled by the release as a function of the gain factor of the respectively associated measuring amplifier, and the output of the summing amplifier representing a signal for earth-fault monitoring.

2. Circuit arrangement for the detection of earth faults on electronic releases for low-voltage circuit breakers having upstream measuring amplifiers (V1, V2, V3), **characterized by** switches (S1, S2, S3), which can be driven in a pulse-width-modulated manner by the release on the basis of the gain factors of the measuring amplifiers (V1, V2, V3) and to which in each case one output of a measuring amplifier (V1, V2, V3) is connected, the outputs of the switches (S1, S2, S3) together being connected to the input of a summing amplifier, whose output represents a signal for earth-fault monitoring.

3. Circuit arrangement according to Claim 2, **characterized in that** the summing amplifier is an integrating amplifier, comprising an operational amplifier (OPV1) having capacitive feedback, whose second input is biased with a reference voltage (Uref), which corresponds to the mean value for the voltage range of the measuring amplifiers (V1, V2, V3).

4. Circuit arrangement according to Claim 2,**characterized in that** the summing amplifier is implemented by a capacitor (C2) having a downstream amplifier (OPV2).

## Revendications

1. Procédé pour détecter une mise à la terre sur des déclencheurs électroniques pour disjoncteurs basse tension équipés d'amplificateurs de mesure connectés en amont, les signaux de sortie des amplificateurs de mesure étant sommés dans un amplificateur totalisateur,
**caractérisé en ce que**
les signaux de sortie des amplificateurs de mesure sont soumis à une modulation d'impulsions par phase, la durée des impulsions étant commandée par le déclencheur en fonction du facteur d'amplification de l'amplificateur de mesure correspondant respectif, et la sortie de l'amplificateur totalisateur représentant un signal pour le contrôle de la mise à la terre.

2. Circuit pour détecter une mise à la terre sur des déclencheurs électroniques pour disjoncteurs basse tension équipés d'amplificateurs de mesure (V1, V2, V3) connectés en amont,
**caractérisé par**
des disjoncteurs (S1, S2, S3) pilotables modulés par largeur d'impulsion par le déclencheur en fonction des facteurs d'amplification des amplificateurs de mesure (V1, V2, V3), disjoncteurs auxquels est conduite respectivement une sortie d'un amplificateur de mesure (V1, V2, V3), les sorties des disjoncteurs (S1, S2, S3) étant conduites en commun à l'entrée d'un amplificateur totalisateur dont la sortie représente un signal pour le contrôle de la mise à la terre.

3. Circuit selon la revendication 2,
**caractérisé en ce que**
l'amplificateur totalisateur est un amplificateur intégrateur, composé d'un amplificateur opérationnel (OPV1) avec rétroaction capacitive, dont la deuxième entrée est polarisée avec une tension de référence (Uref) qui correspond à la valeur moyenne de l'excursion de tension des amplificateurs de mesure (V1, V2, V3).

4. Circuit selon la revendication 2,
**caractérisé en ce que**
l'amplificateur totalisateur est réalisé par un condensateur (C2) équipé d'un amplificateur (OPV2) connecté en aval.
